(19) Europäisches Patentamt / European Patent Office / Office européen des brevets

(11) **EP 3 239 728 B1**

(12) **EUROPEAN PATENT SPECIFICATION**

(45) Date of publication and mention
of the grant of the patent:
**17.06.2020  Bulletin 2020/25**

(51) Int Cl.:
***G01R 31/34*** *(2020.01)*     ***G01R 27/08*** *(2006.01)*

(21) Application number: **15872478.1**

(22) Date of filing: **30.10.2015**

(86) International application number:
**PCT/JP2015/080660**

(87) International publication number:
**WO 2016/103909 (30.06.2016 Gazette 2016/26)**

(54) **DIAGNOSIS DEVICE FOR ELECTRIC MOTOR**

DIAGNOSEVORRICHTUNG FÜR EINEN ELEKTROMOTOR

DISPOSITIF DE DIAGNOSTIC POUR MOTEUR ÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.12.2014   JP 2014264153**

(43) Date of publication of application:
**01.11.2017   Bulletin 2017/44**

(73) Proprietor: **Mitsubishi Electric Corporation
Chiyoda-ku
Tokyo 100-8310 (JP)**

(72) Inventors:
• **MIYAUCHI Toshihiko**
  **Tokyo 100-8310 (JP)**
• **KANEMARU Makoto**
  **Tokyo 100-8310 (JP)**
• **MORI Mitsugi**
  **Tokyo 100-8310 (JP)**
• **TSUKIMA Mitsuru**
  **Tokyo 100-8310 (JP)**

(74) Representative: **Sajda, Wolf E.
Meissner Bolte Patentanwälte
Rechtsanwälte Partnerschaft mbB
Postfach 86 06 24
81633 München (DE)**

(56) References cited:
EP-A1- 2 743 713        JP-A- 2007 228 767
JP-A- 2007 282 300      JP-A- 2014 158 361
US-A- 5 345 158         US-A- 5 594 175
US-B1- 6 262 550        US-B1- 6 366 865

**Description**

TECHNICAL FIELD

The present invention relates to an electric motor diagnosis device which estimates a load torque of a load facility by calculating a winding resistance of an electric motor.

BACKGROUND ART

In a conventional technique for obtaining a winding resistance of an electric motor, for example, a voltage output phase is set to a preset arbitrary phase, and a current command to cause current to flow is first input to operate the electric motor while a proportional integral controller is enabled. After current has flown for a predetermined time, the gain of the proportional integral controller is made zero such that an integrated value is kept constant.

Accordingly, a voltage command value and a current detection value are measured while the voltage command value is fixed. This measurement is performed on current of two different magnitudes, and from the inclination at the time, a primary resistance value (or a line resistance value) is obtained (for example, see Patent Document 1). Other such art is found in US5594175 and US6262550.

CITATION LIST

PATENT DOCUMENT

Patent Document 1: Japanese Laid-Open Patent Publication JP 2002-022813 A (Abstract and FIG. 1)

SUMMARY OF THE INVENTION

PROBLEMS TO BE SOLVED BY THE INVENTION

In an electric motor driven by an inverter, a power converter is included, and a voltage command value can be easily changed by using a proportional integral controller as in Patent Document 1. As a result, a winding resistance value can be calculated. However, when a power converter is not included, the above calculation method as in Patent Document 1 cannot be used therefor.

The present invention has been made in order to solve the above problem, and an object of the present invention is to obtain an electric motor diagnosis device which can accurately estimate a load torque by estimating a winding resistance while a load is connected to an electric motor, even in a case where an electric power converter is not included.

SOLUTION TO THE PROBLEMS

An electric motor diagnosis device according to the present invention includes:

a voltage detection circuit for detecting a voltage of a main circuit connected to an electric motor,
a current detection circuit for detecting a current of the main circuit,
a logical calculation circuit for performing a logical calculation processing on the basis of information from the voltage detection circuit and the current detection circuit,
a sampling speed setting unit, and
a storage unit,
wherein the logical calculation circuit includes an input unit for acquiring and receiving inputs of detection information from the voltage detection circuit and the current detection circuit, rated information of the electric motor, and a sampling speed from the sampling speed setting unit, a calculation unit for calculating a load torque and a winding resistance of the electric motor on the basis of input information from the input unit, by using a preset forgetting coefficient and a preset scale factor, and an output unit for outputting a winding resistance value obtained by the calculation unit.

EFFECT OF THE INVENTION

In the electric motor diagnosis device according to the present invention, on the basis of the detection information from the voltage detection circuit and the current detection circuit, the rated information of the electric motor, and the sampling speed from the sampling speed setting unit, which have been input to the input unit of the logical calculation unit, the calculation unit calculates a load torque and a winding resistance by using a preset forgetting coefficient and a preset scale factor, and outputs the calculation result to the output unit. Therefore, the winding resistance of the electric motor can be accurately estimated because the forgetting coefficient and the scale factor are used. As a result of this, the load torque value can be highly accurately estimated.

BRIEF DESCRIPTION OF THE DRAWINGS

FIG. 1   is a configuration diagram of an electric motor diagnosis device according to a first embodiment of the present invention.
FIG. 2   is a block diagram of the configuration of a logical calculation circuit in FIG. 1.
FIG. 3   is a correlation diagram showing the relationship between a forgetting coefficient and a scale factor with respect to a sampling speed, which is applied to the electric motor diagnosis device according to the first embodiment of the present invention.
FIG. 4   is a flowchart illustrating calculation of a winding resistance by the electric motor diagnosis device according to the first embodiment of the present invention.

DESCRIPTION OF EMBODIMENTS

First Embodiment.

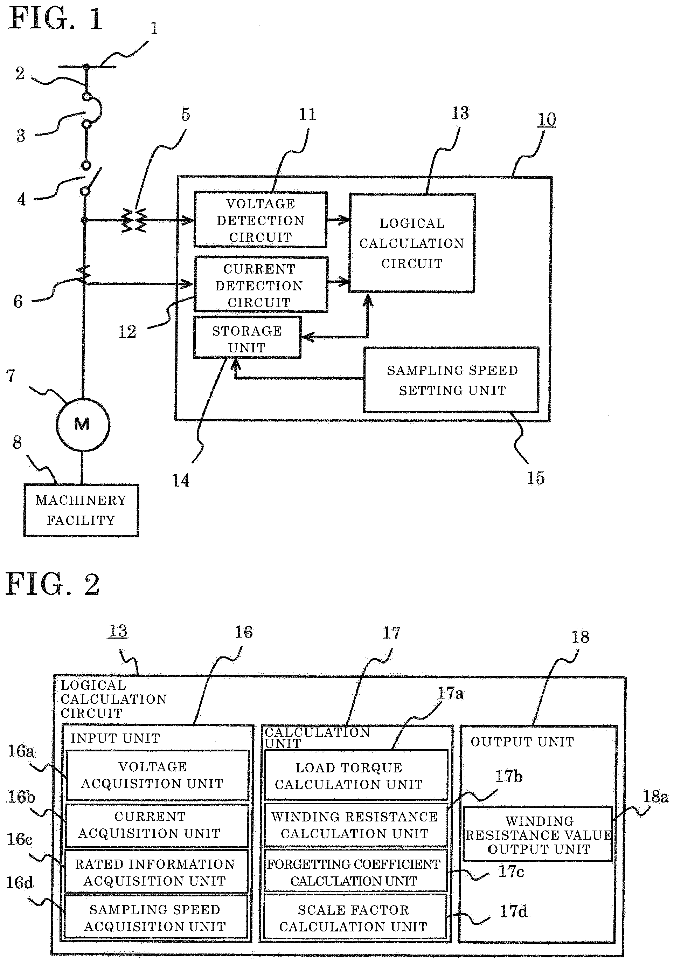

FIG. 1 is a configuration diagram of an electric motor diagnosis device according to a first embodiment of the present invention. The diagnosis device according to the present invention is used in a control center, etc. which is mainly an enclosed switchboard, and thus, FIG. 1 illustrates such a case.
In FIG. 1, in the control center, a main circuit 2, which is branched and drawn from a main busbar 1 of a power system, includes a wiring disconnector 3, an electromagnetic contactor 4, an instrument voltage transformer 5 for detecting the voltage of the main circuit 2, and an instrument current transformer 6 for detecting a load current of the main circuit 2. The main circuit 2 is connected to an electric motor 7 which is a load. For example, the electric motor 7 is a three-phase induction electric motor. A machinery facility 8 is connected to the electric motor 7 so as to be driven to operate.
An electric motor diagnosis device 10 (hereinafter, abbreviated as diagnosis device 10) according to the present invention is connected to the main circuit 2, and is configured as follows.
A voltage detection circuit 11 of the diagnosis device 10 is connected to the instrument voltage transformer 5, converts the detected voltage of the main circuit 2 to a predetermined signal so as to be output to a logical calculation circuit 13 and a storage unit 14.
A current detection circuit 12 is connected to the instrument current transformer 6, converts the detected load current of the main circuit 2 to a predetermined signal so as to be output to the logical calculation circuit 13 and the storage unit 14.
The detected current and voltage here are the voltage and current of a stator coil of the electric motor.
A sampling speed setting unit 15 is connected to the storage unit 14, has a set key (not illustrated), and causes, when the set key is, for example, long-pressed, the storage unit 14 to store and hold therein a desired sampling speed. Data can be stored for a period until the set key is released.
A sampling speed herein refers to a speed of reading a voltage and a current. For example, when a sampling speed is 1 kS/s, 1000 sets of data are acquired per sample per second.
FIG. 2 is a block diagram of the configuration of the logical calculation circuit 13 of the diagnosis device 10.
The logical calculation circuit 13 is formed of an input unit 16, a calculation unit 17, and an output unit 18.
The input unit 16 includes a voltage acquisition unit 16a, a current acquisition unit 16b, a rated information acquisition unit 16c, and a sampling speed acquisition unit 16d.
The voltage acquisition unit 16a acquires a voltage value transmitted from the voltage detection circuit 11. The current acquisition unit 16b acquires a current value transmitted from the current detection circuit 12.
The rated information acquisition unit 16c acquires information about the electric motor 7 to be diagnosed, such as the rated output, the rated voltage, the rated current, the number of poles, and the rotational frequency. Such rated information can be easily acquired from a catalog of the manufacturer of the electric motor, or a name plate attached to the electric motor. The rated information of corresponding electric motors is input to and stored in the storage unit 14 in advance to be used. If the rated information is not available, the information may be estimated from measurement data.
The sampling speed acquisition unit 16d acquires, as a sampling speed for measurement, a sampling speed that is set by the sampling speed setting unit 15 and stored in the storage unit 14 in advance. The sampling speed may be calculated from measurement data obtained through measurement.

The calculation unit 17 includes a load torque calculation unit 17a, a winding resistance calculation unit 17b, a forgetting coefficient calculation unit 17c, and a scale factor calculation unit 17d. The winding resistance is specifically the resistance of the stator coil of the electric motor, and is described as a stator resistance in expressions below.

The load torque calculation unit 17a calculates a load torque Te from a voltage value acquired by the voltage acquisition unit 16a and a current value acquired by the current acquisition unit 16b, by the following Expression (1).

[Expression 1]
Expression 1

$$T_e = \frac{3}{2} \cdot P_p \cdot \left\{ (\phi_d \cdot i_q) - (\phi_q \cdot i_d) \right\} \quad \cdots\cdots (1)$$

In the Expression (1), $P_p$ represents the number of magnetic poles, $\varphi_d$, $\varphi_q$ each represent a stator coil inter-linkage flux, and $i_q$, $i_d$ each represent a stator current.

In the above and following expressions, the subscripts d, q represent magnetic fluxes, currents, or voltages in a d-axis direction and a q-axis direction, respectively, when a current and a voltage are d-q transformed.

In Expression (1), the stator currents $i_q$, $i_d$ are calculated from the acquired three-phase current through d-q transformation. The inter-linkage fluxes $\varphi_d$, $\varphi_q$ are calculated from the following Expressions (2) and (3), respectively.

[Expression 2]
Expression 2

$$\frac{d\phi_d}{dt} = v_d - \left( i_d \cdot R_s \right) \quad \cdots\cdots (2)$$

[Expression 3]
Expression 3

$$\frac{d\phi_q}{dt} = v_q - \left( i_q \cdot R_s \right) \quad \cdots\cdots (3)$$

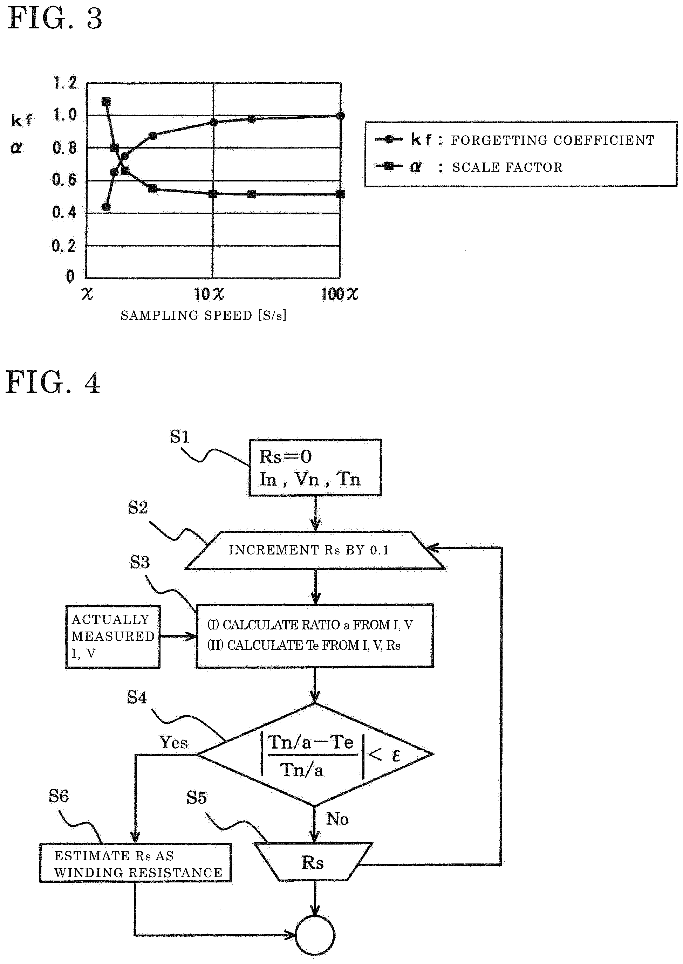

The stator voltages $v_d$, $v_q$ in Expressions (2) and (3) are calculated from the acquired three-phase voltage through d-q conversion. $R_s$ represents a stator resistance. This $R_s$ is identical to $R_s$ of a flowchart in FIG. 4 described below, and is not a constant value. Rs varies along with the progress of the steps in the flowchart, and is finally defined to one value. The above Expressions (2) and (3) are expressed by differentiation. When numerical analysis is performed thereon, the following Expressions (4) and (5) are obtained.

In the expressions, the symbol $\Psi$ indicates numerical analysis of the stator coil inter-linkage flux. In addition, $k_f$ represents a forgetting coefficient, and $\Delta t$ represents a sampling time width.

The subscript n indicates a variable used for convenience in numerical calculation, and n-1 indicates that an n-1-th value is used and n indicates that an n-th value is used. Thus, n takes a value of 1, 2, 3 .....

[Expression 4]
Expression 4

$$\Psi_d^n = k_f \cdot \Psi_d^{n-1} + \left\{ v_d^{n-1} + v_d^n - (i_d^{n-1} + i_d^n) \cdot R_s \right\} \cdot \frac{\Delta t}{2} \cdots (4)$$

[Expression 5]
Expression 5

$$\Psi_q^n = k_f \cdot \Psi_q^{n-1} + \left\{ v_q^{n-1} + v_q^n - (i_q^{n-1} + i_q^n) \cdot R_s \right\} \cdot \frac{\Delta t}{2} \cdots (5)$$

When currents including high frequency components or the like are integrated, the gain is influenced by a data-sampling (A/D conversion) speed and a phase delay. The gain is generally expressed by a product of a filter gain in the input unit (A/D conversion) and a time constant of the forgetting coefficient $k_f$, and thus, needs to be adjusted by a scale factor $\alpha$.

Therefore, the calculation results of the following Expressions (6) and (7) in which the scale factor $\alpha$ as a coefficient is integrated to the respective results of calculation of Expressions (4) and (5), are identified as final results of the magnetic flux.

The symbol "^" above $\Psi$ in Expressions (6) and (7) indicates an identification value.

[Expression 6]
Expression 6

$$\widehat{\Psi}_d^n = \alpha \cdot \Psi_d^n \qquad \cdots\cdots (6)$$

[Expression 7]
Expression 7

$$\widehat{\Psi}_q^n = \alpha \cdot \Psi_q^n \qquad \cdots\cdots (7)$$

Regarding the forgetting coefficient $k_f$ and a scale factor $\alpha$, in the forgetting coefficient calculation unit 17c and the scale factor calculation unit 17d of the calculation unit 17, correlation data of the forgetting coefficient $k_f$ and the scale factor $\alpha$ for each sampling speed obtained in advance through measurement is acquired to create a data table. The data table is stored in the storage unit 14.

In the measurement, for example, a result measured in advance by the manufacturer of the diagnosis device may be used. In that case, the data is already known before the device is operated. Since a sampling speed and a forgetting coefficient $k_f$, and a sampling speed and a scale factor $\alpha$ are each in a one-to-one relation, a forgetting coefficient $k_f$ and a scale factor $\alpha$ are uniquely determined for a corresponding sampling speed.

FIG. 3 is a diagram showing an example of the correlation between a forgetting coefficient $k_f$ and a scale factor $\alpha$ with respect to a sampling speed. This information needs to be incorporated as a data table into the calculation unit 17 in advance. To incorporate the information, the values may be stored in a memory or the like of the storage unit 14. In a case where a sampling speed value not included in the data table is to be input, a forgetting coefficient and a scale factor with respect to an approximate value resulted from statistical processing such as a least-squares method, for example, are used.

By using the data table, values of a forgetting coefficient $k_f$ and a scale factor $\alpha$ are assigned to the above expressions, and calculation thereof is performed.

Next, steps for the calculation unit 17 to calculate a winding resistance (a stator resistance) are described.

FIG. 4 is a flowchart showing steps of calculating a winding resistance.

At step S1 (abbreviated as S1, the same applies hereinafter), a rated current In, a rated voltage Vn, and a rated torque Tn acquired by the rated information acquisition unit 16c are input in advance.

The subscript n in In, Vn, and Tn indicates a rated matter.

Initially, a stator resistance Rs = 0 is assumed.

Next, at step S2, Rs is incremented by 0.1 $\Omega$, for example.

Next, at step S3, measured values I, V are acquired from the current acquisition unit 16b and the voltage acquisition unit 16a, and a ratio a of the measured current I and the rated current In is calculated. The ratio a is obtained by a = In/I. Alternatively, the ratio a may be obtained by a = $(In/I)^2$.

The load torque Te is calculated using Expression (1) on the basis of I, V, and Rs.

For example, when the measured I and V are equal to the rated current and the rated voltage, respectively, the measurement result based on I, V, and Rs should match the rated torque.

Next, at step S4, Rs at which the measurement result based on I, V, and Rs matches the rated torque Tn is selected. For example, when Rs is too small or large, the measurement result based on I, V, and Rs does not match the rated torque Tn. Rs at which a difference between the calculated torque and the rated torque value is minimum is output as a stator resistance value. A threshold $\varepsilon$ is used as an error rate. The threshold $\varepsilon$ is preferably small, and, for example, set to 0.01.

That is, when the absolute value of (Tn/a-Te)/(Tn/a) is greater than the threshold $\varepsilon$ at step S4, the processing returns from step S5 to 52, Rs is incremented, and calculation is performed again. When the absolute value becomes less than the threshold $\varepsilon$ (Yes at step S4), Rs is estimated to be a winding resistance at step S6 and the processing is ended.

This winding resistance value is output to a winding resistance value output unit 18a of the output unit 18.

In this way, the winding resistance of the stator can be accurately estimated, and a load torque which ranges from no load to the rated torque can be highly accurately estimated by using the winding resistance. As a result of using the forgetting coefficient and the scale factor, divergence in calculation of numerical values can be prevented so that a torque estimation error can be reduced.

It was confirmed that the winding resistance estimation error was approximately 23% or lower, and the torque estimation accuracy was approximately 3%, for example.

Since a load torque value can be highly accurately estimated, an abnormality in the electric motor can be easily determined by detecting a torque abnormality caused by occurrence of an overload, a sudden torque, or the like.

A torque abnormality may be determined by setting a threshold in advance. Alternatively, when a torque varies differently from usual, an abnormality may be determined through a neural network or other statistical processing. For normal torque variation, a learning time period is necessary.

When operation of the electric motor continues, aged deterioration of the winding progresses and the winding resistance (the stator resistance) changes. Accordingly, if adoption of the initial winding resistance value is continued, an estimated winding resistance value for a winding after aged deterioration differs from the actual winding resistance value, and thus, torque estimation accuracy lowers.

Therefore, regular update in which the winding resistance value is updated once a month, for example, is performed. Alternatively, an update timing may be freely set. Alternatively, for example, the winding resistance value may be updated every current-flowing time period, which is equivalent to one month, by calculating a total current-flowing time from a current waveform.

Moreover, the winding resistance value varies depending on the temperature. The temperature means not only the external environment temperature, but also the stator winding temperature, which is increased when the inside of the electric motor is heated by continuous operation.

As a result, the winding resistance value is increased. In order to avoid such a problem, information on a temperature, which is measured at the same time by a temperature sensor provided to the target electric motor, may be acquired such that a winding resistance at a reference temperature can be calculated.

The winding resistance value increases in proportion to the temperature. Further, the temperature increase value is determined depending on a resistor temperature coefficient. Accordingly, when the resistor temperature coefficient is input in advance, the winding resistance value can be corrected to that at the reference temperature.

A load torque varies temporally depending on plant equipment such as a pump, a fan, a blower, and a conveyor, installed in a power plant or a chemical plant. However, the electric motor diagnosis device according to the present invention is applicable to any induction electric motor that is not driven by an inverter.

In the description so far, one diagnosis device is provided for an individual electric motor. However, one diagnosis device may collectively process information about a plurality of electric motors and calculate winding resistances of the plurality of electric motors.

That is, the voltage detection circuit and the current detection circuit detect information on a current and a voltage of each of the plurality of electric motors, the rated information of the plurality of electric motors is input to the input unit in advance, and the calculation unit calculates the load torque and the winding resistance of each of the plurality of electric motors.

As described above, the electric motor diagnosis device according to the first embodiment includes: the voltage detection circuit for detecting a voltage of the main circuit connected to the electric motor; the current detection circuit for detecting a current of the main circuit; the logical calculation circuit for performing logical calculation processing on the basis of information from the voltage detection circuit and the current detection circuit; the sampling speed setting unit; and the storage unit.

The logical calculation circuit includes: the input unit for acquiring and receiving inputs of detection information from the voltage detection circuit and the current detection circuit, rated information of the electric motor, and a sampling speed from the sampling speed setting unit; the calculation unit for calculating a load torque and a winding resistance of the electric motor on the basis of input information from the input unit by using a preset forgetting coefficient and a preset scale factor; and the output unit for outputting a winding resistance value obtained by the calculation unit.

Therefore, the winding resistance value of the electric motor can be accurately estimated because the forgetting coefficient and the scale factor are used. As a result of this, the torque value can be also highly accurately estimated.

In addition, the relationship between forgetting coefficients and scale factors with respect to the corresponding sampling speeds is acquired and stored as a database in the storage unit, and a forgetting coefficient and a scale factor corresponding to a set sampling speed are used with reference to the database. Therefore, the winding resistance can be easily and accurately calculated by using the forgetting coefficient and the scale factor corresponding to the measured sampling speed.

In addition, information on the stator winding temperature is acquired from the temperature sensor provided to the electric motor, and the winding resistance value is corrected according to the acquired temperature. Therefore, the winding resistance can be accurately calculated while influence of variation in stator winding temperature is eliminated.

Furthermore, the voltage detection circuit and the current detection circuit detect currents and voltages of a plurality of electric motors, the detected currents and voltages together with the rated information of the plurality of electric motors are input to the input unit in advance, and the calculation unit calculates load torques and winding resistances of the plurality of electric motors. Therefore, processing can be performed collectively on the plurality of electric motors. For example, when the electric motor diagnosis device is installed in a control center or the like, the size of the device can be reduced.

It is noted that, within the scope of the present invention, the above embodiment may be modified or simplified as appropriate.

DESCRIPTION OF THE REFERENCE CHARACTERS

| | |
|---|---|
| 1 | main busbar |
| 2 | main circuit |
| 3 | wiring disconnector |
| 4 | electromagnetic contactor |
| 5 | instrument voltage transformer |
| 6 | instrument current transformer |
| 7 | electric motor |
| 8 | machinery facility |
| 10 | diagnosis device |
| 11 | voltage detection circuit |
| 12 | current detection circuit |
| 13 | logical calculation circuit |
| 14 | storage unit |
| 15 | sampling speed setting unit |
| 16 | input unit |
| 16a | voltage acquisition unit |
| 16b | current acquisition unit |
| 16c | rated information acquisition unit |
| 16d | sampling speed acquisition unit |
| 17 | calculation unit |
| 17a | load torque calculation unit |
| 17b | winding resistance calculation unit |
| 17c | forgetting coefficient calculation unit |
| 17d | scale factor calculation unit |
| 18 | output unit |
| 18a | winding resistance value output unit |

**Claims**

1. An electric motor diagnosis device comprising:

   - a voltage detection circuit (11) for detecting a voltage of a main circuit (2) connected to an electric motor (7);
   - a current detection circuit (12) for detecting a current of the main circuit (2);
   - a logical calculation circuit (13) for performing a logical calculation processing on the basis of information from the voltage detection circuit (11) and the current detection circuit (12);
   - a sampling speed setting unit (15); and
   - a storage unit (14),
   wherein the logical calculation circuit (13) includes

   - an input unit (16) for acquiring and receiving inputs of detection information from the voltage detection circuit (11) and the current detection circuit (12), rated information of the electric motor (7), and a sampling speed from the sampling speed setting unit (15),
   - a calculation unit (17) for calculating a load torque and a winding resistance of the electric motor (7) on the basis of input information from the input unit (16), by using a preset forgetting coefficient and a preset scale factor, and
- an output unit (18) for outputting a winding resistance value obtained by the calculation unit (17).

2. The electric motor diagnosis device according to claim 1,
wherein a relationship between the forgetting coefficient and the scale factor with respect to the sampling speed is acquired and stored as a database in the storage unit (14) in advance, by the electric motor diagnosis device, and the forgetting coefficient and the scale factor corresponding to the set sampling speed are used for the calculation by the calculation unit (17) with reference to the database.

3. The electric motor diagnosis device according to claim 1 or 2, wherein information on the temperature of a stator winding is acquired from a temperature sensor provided to the electric motor (7), and the winding resistance value is corrected according to the acquired temperature.

4. The electric motor diagnosis device

according to any one of claims 1 to 3,
wherein the voltage detection circuit (11) and the current detection circuit (12) are adapted to detect current information and voltage information of a plurality of the electric motors (7), the current information and the voltage information together with rated information of the plurality of electric motors (7) are input to the input unit (16) in advance by the calculation in the calculation unit (17), and the calculation unit (17) is adapted to calculate the load torques and the winding resistances of the plurality of the electric motors (7).

**Patentansprüche**

1. Elektromotor-Diagnosegerät, die Folgendes aufweist:

- eine Spannungsdetektierschaltung (11) zum Detektieren einer Spannung einer Hauptschaltung (2), die mit einem Elektromotor (7) verbunden ist;
- eine Stromdetektierschaltung (12) zum Detektieren eines Stroms der Hauptschaltung (2);
- eine Logik-Rechenschaltung (13) zum Durchführen einer Logik-Berechnungsverarbeitung auf der Basis von Informationen von der Spannungsdetektierschaltung (11) und der Stromdetektierschaltung (12);
- eine Abtastgeschwindigkeits-Vorgabeeinheit (15); und
- eine Speichereinheit (14),
wobei die Logik-Rechenschaltung (13) Folgendes aufweist:
- eine Eingabeeinheit (16) zum Erfassen und Empfangen von Eingaben von Detektierinformationen von der Spannungsdetektierschaltung (11) und der Stromdetektierschaltung (12), Nennwert-Informationen des Elektromotors (7) und der Abtastgeschwindigkeit von der Abtastgeschwindigkeits-Vorgabeeinheit (15),
- eine Berechnungseinheit (17) zum Berechnen eines Lastdrehmoments und eines Wicklungswiderstands des Elektromotors (7) auf der Basis von Eingabeinformationen von der Eingabeeinheit (16) unter Verwendung eines vorgegebenen Vergessenskoeffizienten und eines vorgegebenen Skalierungsfaktors, und
- eine Ausgabeeinheit (18) zum Ausgeben eines von der Berechnungseinheit (17) erhaltenen Wicklungswiderstandswertes.

2. Elektromotor-Diagnosegerät nach Anspruch 1,
wobei eine Relation zwischen dem Vergessenskoeffizienten und dem Skalierungsfaktor in Bezug auf die Abtastgeschwindigkeit im Voraus von der Elektromotor-Diagnosevorrichtung erfasst und als eine Datenbank in der Speichereinheit (14) gespeichert wird, und wobei der Vergessenskoeffizient und der Skalierungsfaktor, die der vorgegeben Abtastgeschwindigkeit entsprechen, für die Berechnung von der Berechnungseinheit (17) unter Bezugnahme auf die Datenbank verwendet werden.

3. Elektromotor-Diagnosegerät nach Anspruch 1 oder 2,

wobei Informationen über die Temperatur einer Statorwicklung von einem Temperatursensor erfasst werden, der an dem Elektromotor (7) angebracht ist, und
wobei der Wicklungswiderstandswert in Abhängigkeit von der erfassten Temperatur korrigiert wird.

4. Elektromotor-Diagnosegerät nach einem der Ansprüche 1 bis 3, wobei die Spannungsdetektierschaltung (11) und die Stromdetektierschaltung (12) dazu ausgelegt sind, Strominformationen und Spannungsinformationen von einer Vielzahl von Elektromotoren (7) zu detektieren, wobei die Strominformationen und die Spannungsinformationen zusammen mit Nennwert-Informationen der Vielzahl von Elektromotoren (7) durch die Berechnung in der Berechnungseinheit (17) vorab in die Eingabeeinheit (16) eingegeben werden, und wobei die Berechnungseinheit (17) dazu ausgelegt ist, die Lastmomente und die Wicklungswiderstände der Vielzahl von Elektromotoren (7) zu berechnen.

**Revendications**

1.  Dispositif de diagnostic de moteur électrique comprenant :

    - un circuit de détection de tension (11) pour détecter une tension d'un circuit principal (2) connecté à un moteur électrique (7) ;
    - un circuit de détection de courant (12) pour détecter un courant du circuit principal (2) ;
    - un circuit de calcul logique (13) pour effectuer un traitement de calcul logique sur la base des informations provenant du circuit de détection de tension (11) et du circuit de détection de courant (12) ;
    - une unité de réglage de vitesse d'échantillonnage (15) ; et
    - une unité de stockage (14),
    dans lequel le circuit de calcul logique (13) inclut
    - une unité d'entrée (16) pour acquérir et recevoir des entrées d'informations de détection provenant du circuit de détection de tension (11) et du circuit de détection de courant (12), des informations nominales du moteur électrique (7) et une vitesse d'échantillonnage provenant de l'unité de réglage de vitesse d'échantillonnage (15),
    - une unité de calcul (17) pour calculer un couple de charge et une résistance d'enroulement du moteur électrique (7) sur la base d'informations d'entrée provenant de l'unité d'entrée (16), en utilisant un coefficient d'oubli préréglé et un facteur d'échelle préréglé, et
    - une unité de sortie (18) pour délivrer une valeur de résistance d'enroulement obtenue par l'unité de calcul (17).

2.  Dispositif de diagnostic de moteur électrique selon la revendication 1, dans lequel une relation entre le coefficient d'oubli et le facteur d'échelle par rapport à la vitesse d'échantillonnage est acquise et stockée à l'avance sous la forme d'une base de données dans l'unité de stockage (14) par le dispositif de diagnostic de moteur électrique, et le coefficient d'oubli et le facteur d'échelle correspondant à la vitesse d'échantillonnage réglée sont utilisés pour le calcul par l'unité de calcul (17) en se référant à la base de données.

3.  Dispositif de diagnostic de moteur électrique selon la revendication 1 ou 2, dans lequel des informations sur la température d'un enroulement de stator sont acquises à partir d'un capteur de température prévu sur le moteur électrique (7), et la valeur de résistance d'enroulement est corrigée en fonction de la température acquise.

4.  Dispositif de diagnostic de moteur électrique selon l'une quelconque des revendications 1 à 3, dans lequel le circuit de détection de tension (11) et le circuit de détection de courant (12) sont adaptés à détecter des informations de courant et des informations de tension d'une pluralité de moteurs électriques (7), les informations de courant et les informations de tension ainsi que les informations nominales de la pluralité de moteurs électriques (7) sont entrées à l'avance dans l'unité d'entrée (16) par le calcul dans l'unité de calcul (17), et l'unité de calcul (17) est adaptée à calculer les couples de charge et les résistances d'enroulement de la pluralité de moteurs électriques (7).

## FIG. 1

## FIG. 2

# FIG. 3

SAMPLING SPEED [S/s]

kf : FORGETTING COEFFICIENT
α : SCALE FACTOR

# FIG. 4

S1 — $Rs=0$ $In$ , $Vn$ , $Tn$

S2 — INCREMENT Rs BY 0.1

S3 — (I) CALCULATE RATIO a FROM I, V
(II) CALCULATE Te FROM I, V, Rs

ACTUALLY MEASURED I, V

S4 — $\left| \dfrac{Tn/a - Te}{Tn/a} \right| < \varepsilon$

Yes

No

S6 — ESTIMATE Rs AS WINDING RESISTANCE

S5 — Rs

**REFERENCES CITED IN THE DESCRIPTION**

**Patent documents cited in the description**

- US 5594175 A
- US 6262550 B

- JP 2002022813 A